# EUROPEAN PATENT SPECIFICATION

(11) **EP 4 475 167 B1**
(45) Date of publication and mention of the grant of the patent: **30.07.2025**
(21) Application number: 23177665.9
(22) Date of filing: 06.06.2023
(51) Int. Cl.: H01L 21/50, H01L 23/10, H01L 23/053, H01L 23/24, H01L 23/498, H01L 25/07

(54) **METHODS FOR PRODUCING A SEAL FOR A SEMICONDUCTOR MODULE, AND A HOUSING FOR A SEMICONDUCTOR MODULE**
VERFAHREN ZUR HERSTELLUNG EINER DICHTUNG FÜR EIN HALBLEITERMODUL UND GEHÄUSE FÜR EIN HALBLEITERMODUL
PROCÉDÉS DE FABRICATION D'UN JOINT POUR UN MODULE SEMI-CONDUCTEUR ET BOÎTIER POUR UN MODULE SEMI-CONDUCTEUR

(43) Date of publication of application: 11.12.2024
(73) Proprietor: Infineon Technologies AG, 85579 Neubiberg (DE)
(72) Inventor: TROSKA, Georg, 58730 Fröndenberg/Ruhr (DE); JÄGER, Fabian, 59909 Bestwig (DE); WIESEMANN, Markus, 33605 Bielefeld (DE); HERZER, Anita, 67655 Kaiserslautern (DE)
(74) Representative: Westphal, Mussgnug & Partner, Patentanwälte mbB

(56) References cited:
- US-A1- 2022 344 236
- US-B1- 6 428 650

## Description

### TECHNICAL FIELD

The instant disclosure relates to a method for producing a seal for a semiconductor module, and to a housing for a semiconductor module.

### BACKGROUND

Power semiconductor module arrangements often include at least one semiconductor substrate arranged in a housing. A semiconductor arrangement including a plurality of controllable semiconductor elements (e.g., two IGBTs in a half-bridge configuration) is arranged on each of the at least one substrates. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate. The controllable semiconductor devices are usually mounted onto the semiconductor substrate by soldering or sintering techniques.

The components of the semiconductor module arrangement are usually protected from mechanical damage or other environmental impacts by means of a housing. The housing needs to be securely mounted either to the substrate or to the base plate, for example. A seal may be arranged between the housing and the substrate or base plate in order to prevent particles or gases from entering the inside of the housing.

Document US 2022/344236 A1 discloses a package having a cavity to be sealed by a lid. The package includes a heat sink having a coefficient of thermal expansion of 9 ppm/° C. or more and 15 ppm/° C. or less from 25 ° C. to 100 ° C. and a frame disposed on the heat sink, made of ceramics, and surrounding the cavity in plan view. An outer edge of the frame includes a first linear portion extending along a first direction, a second linear portion extending along a second direction orthogonal to the first direction, and a chamfer connecting the first linear portion and the second linear portion in plan view.

Document US 6 428 650 B1 discloses an optical device enclosed within a package or module having an optically transmissive or transparent cover that is sealed with an adhesive preform that has been pre-applied onto the bonding areas of the cover. The adhesive preforms are formed of a wet adhesive deposited on a sheet of optically transmissive or transparent material as a preform in predetermined locations and are B-staged or dried to form dry solid adhesive preforms. The preforms may be continuous or have one or more small gaps therein. The sheet of optical material is diced or singulated to produce individual optical covers having an adhesive preform thereon.

There is a need for a semiconductor module arrangement that offers protection for the semiconductor components arranged therein such that the overall lifetime of the power semiconductor module arrangement is increased.

### SUMMARY

The invention is set out in the appended set of claims.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement that does not fall within the scope of the claimed invention.
Figure 2 is a cross-sectional view of another power semiconductor module arrangement that does not fall within the scope of the claimed invention.
Figure 3, including Figure 3A that illustrates a conventional method for forming a seal that does not fall within the scope of the claimed invention and Figure 3B that illustrates a method for forming a seal according to one embodiment that falls within the scope of the claimed invention.
Figures 4, 5 and 6 schematically illustrate a method for producing a seal for a semiconductor module according to one embodiment that falls within the scope of the claimed invention.
Figure 7 is a top view of an exemplary seal for a power semiconductor module arrangement that falls within the scope of the claimed invention.
Figure 8, including Figures 8A and 8B, is a cross-sectional view of a housing for a power semiconductor module arrangement, that falls within the scope of the claimed invention, with a seal formed thereon.
Figure 9, including Figures 9A and 9B, is a cross sectional view of a sidewall of a housing, that falls within the scope of the claimed invention, with a seal formed thereon.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

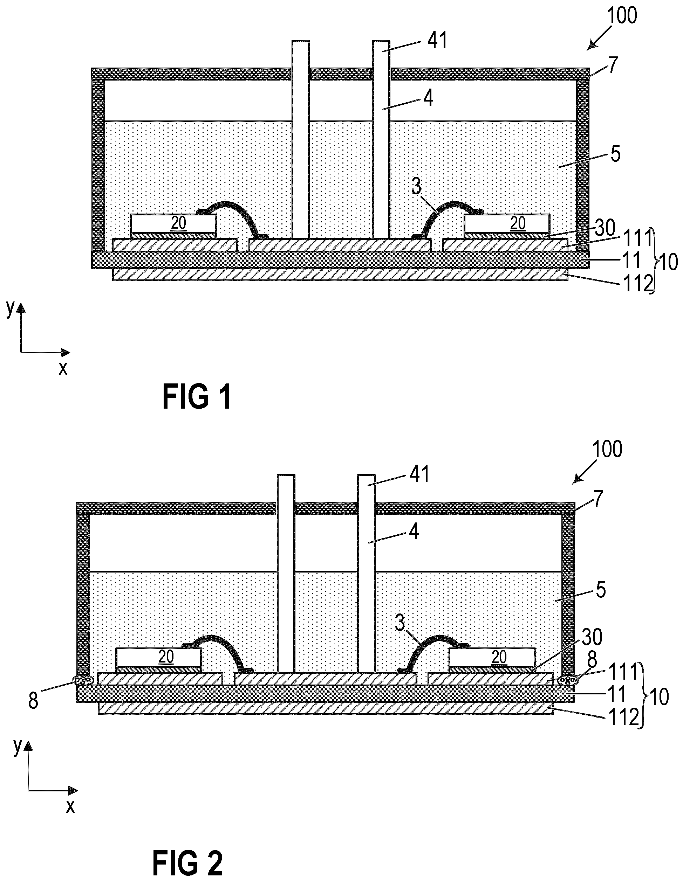

Referring to Figure 1, a cross-sectional view of a power semiconductor module arrangement 100, that does not fall within the scope of the claimed invention, is illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 forms a ground surface of the housing 7, while the housing 7 itself solely comprises sidewalls and a cover. This is, however, only an example. It is also possible that the substrate 10 is mounted on a base plate. In some power semiconductor module arrangements 100, more than one substrate 10 is arranged on a single base plate. A base plate may form a ground surface of the housing 7, for example. That is, the sidewalls of the housing 7 may be attached to the base plate, thereby covering the at least one substrate 10.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable or non-controllable semiconductor element.

The one or more semiconductor bodies 20 may form a semiconductor arrangement on the substrate 10. In Figure 1, only two semiconductor bodies 20 are exemplarily illustrated. The second metallization layer 112 of the semiconductor substrate 10 in Figure 1 is a continuous layer. It is, however, also possible to omit the second metallization layer 112. It is also possible that the second metallization layer 112 is a structured layer. The first metallization layer 111 is a structured layer in the example illustrated in Figure 1. "Structured layer" in this context means that the first metallization layer 111 is not a continuous layer, but includes recesses between different sections of the layer. Such recesses are schematically illustrated in Figure 1. The first metallization layer 111 in this example includes three different sections. Different semiconductor bodies 20 may be mounted on the same or to different sections of the first metallization layer 111. Different sections of the first metallization layer may have no electrical connection or may be electrically connected to one or more other sections using, e.g., bonding wires 3. Electrical connections 3 may also include bonding ribbons, connection plates or conductor rails, for example, to name just a few examples. The one or more semiconductor bodies 20 may be electrically and mechanically connected to the substrate 10 by an electrically conductive connection layer 30. Such an electrically conductive connection layer may be a solder layer, a layer of an electrically conductive adhesive, or a layer of a sintered metal powder, e.g., a sintered silver powder, for example.

The power semiconductor module arrangement 100 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end, while a second end 41 of the terminal elements 4 protrudes out of the housing 7. The terminal elements 4 may be electrically contacted from the outside at their second end 41. Such terminal elements 4, however, are only an example. The components inside the housing 7 may be electrically contacted from outside the housing 7 in any other suitable way. For example, terminal elements 4 may be arranged closer or adjacent to the sidewalls of the housing 7. It is also possible that terminal elements 4 protrude vertically or horizontally through the sidewalls of the housing 7. It is even possible that terminal elements 4 protrude through a ground surface of the housing 7.

The semiconductor bodies 20 each may include a chip pad metallization, e.g., a source, drain, anode, cathode or gate metallization. A chip pad metallization generally provides a contact surface for electrically connecting the semiconductor body 20. The chip pad metallization may electrically contact a connection layer 30, a terminal element 4, or an electrical connection 3, for example. A chip pad metallization may consist of or include a metal such as aluminum, copper, gold or silver, for example. The electrical connections 3 and the terminal elements 4 may also consist of or include a metal such as copper, aluminum, gold, or silver, for example.

The power semiconductor module arrangement 100 further includes a casting compound 5. The casting compound 5 may consist of or include a silicone gel, a silicone, polyurethane, epoxy, or polyacrylate based isolation material, or may be a rigid molding compound, for example. The casting compound 5 may at least partly fill the interior of the housing 7, thereby covering the components and electrical connections that are arranged on the substrate 10. The terminal elements 4 may be partly embedded in the casting compound 5. At least their second ends 41, however, are not covered by the casting compound 5 and protrude from the casting compound 5 through the housing 7 to the outside of the housing 7. The casting compound 5 is configured to protect the components and electrical connections inside the power semiconductor module 100, in particular inside the housing 7, from certain environmental conditions and mechanical damage. The casting compound 5 may be formed by dispensing a material, for example, an uncured dielectric gel, into the housing 7, after the housing 7 has been mounted to a substrate 10 or to a base plate, and then curing the material.

The housing 7 encloses the arrangement and provides further protection from certain environmental conditions and mechanical damage. As has been described above, the housing 7 may be attached to the substrate 10 or, if the substrate 10 is arranged on a base plate, the housing 7 may be attached to the base plate, for example. In order to prevent the casting compound 5 from leaking out between the housing 7 and the substrate 10 or base plate, and to prevent contaminants or gasses (e.g., corrosive gasses) from entering the inside of the housing 7, a seal 8 may be arranged between the housing 7 and the substrate 10 (or between the housing 7 and the base plate). Referring to Figure 2, a semiconductor module arrangement 100 not falling within the scope of the claimed invention, and comprising a seal 8 between the substrate 10 and the housing 7 is schematically illustrated.

In order to form the seal 8, the material of the seal 8 may be applied on the substrate 10 (or base plate) or to the housing 7 in a liquid or viscous form. The housing 7 may then be arranged on the substrate 10 (or base plate), with the material of the seal 8 arranged between the housing 7 and the substrate 10 (or base plate). The material of the seal 8 may then be cured, e.g., by heating the arrangement. During the curing process, the presence of contaminants may cause the formation of air bubbles and unwanted cavities in the seal 8 which may decrease the sealing abilities of the seal 8. Measurements to avoid unwanted bubble formation lead to higher costs due to additional process steps and/or longer cycle times. Furthermore, components of the viscous seal 8 can interact with other module components, especially during heating, until solidification which can have an adverse impact on the module negative, e.g., through reduced cycle times.

In addition, there is a risk that contaminants in the material forming the seal will interfere with the curing process such that non-solidified (non-cured) material remains between the housing and the cured parts of the seal 8. This may also result in reduced sealing abilities of the seal 8. For example, corrosive gasses may be able to enter the housing 7 through a non-solidified layer of sealing material.

It is therefore important to prevent air from penetrating into the material 90, so the seal 8 is free of any unwanted air bubbles or cavities. Even further, any fluids or moisture that may be present in the housing 7 should be prevented from penetrating into the seal 8. The seal 8, therefore, should also be free of any unwanted air bubbles and uncured material. Measurements to avoid unwanted bubble formation lead to higher costs due to additional process steps and/or longer cycle times.

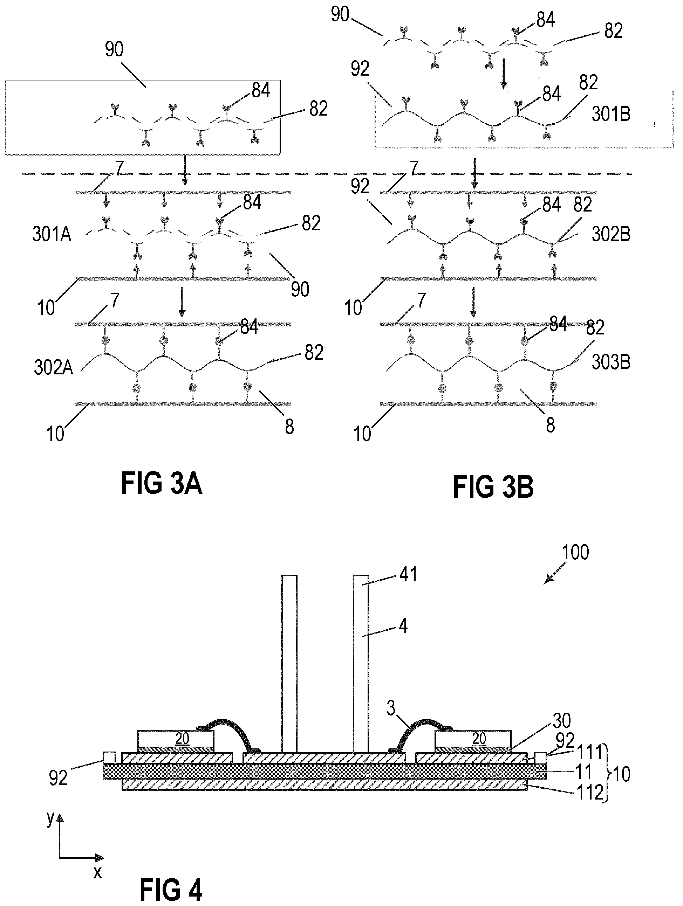

Now referring to Figure 3A, a conventional process that does not fall within the scope of the claimed invention, for forming a seal is schematically illustrated. The liquid or viscous material 90 (illustrated inside the box at the top of Figure 3A) is dispensed on the respective surface of the substrate 10, base plate, or housing 7 (step 301A), and, once the housing 7 has been arranged on the substrate 10 or base plate, with the material 90 arranged therebetween, the material 90 is cured (step 302A). The material 90 generally comprises a matrix material 82, e.g., a silicone-based matrix material, and an adhesion promoter 84. Adhesion promoters, often also referred to as coupling agents, are chemicals that act at the interface between two different materials (e.g., an organic polymer such as the matrix material, and an inorganic material such as the housing, substrate and base plate) to enhance adhesion between the two materials. Organic and inorganic materials are very different in many ways, for example, compatibility, chemical reactivity, surface properties, and coefficient of thermal expansion, such that forming a strong adhesive bond between each of these two dissimilar materials and the matrix material 82 is difficult. An adhesion promoter 84 acts effectively at the interface between the matrix material 82 and each of the organic and inorganic materials (e.g., the interface between matrix material 82 and housing 7, and the interface between matrix material 82 and substrate 10 or base plate) to chemically and physically wed each of these dissimilar materials with the matrix material 82 via a strong cohesive bond structure.

The curing process is usually performed at temperatures that are high enough and applied for a sufficient duration to solidify (cure) the matrix material 82 and activate the adhesion promoter 84. That is, during the curing process, a crosslinking process occurs and the adhesion promoter 84 is activated, resulting in certain adhesion properties of the resulting seal 8. Once activated, the adhesion promoter is consumed, such that it becomes unreactive, i.e. it cannot be activated again at a later time.

Now referring to Figure 3B, a method according to one embodiment falling within the scope of the claimed invention, is schematically illustrated. A material 90 comprising a silicone based matrix material 82 and an adhesion promoter 84 are provided. The material 90 may be the same or similar to the material 90 described with respect to Figure 3A. In a first step (step 301B), the material 90 is heated to a first temperature. The first temperature, however, is lower than the temperature that is required to activate the adhesion promoter 84, or is applied for a duration that is too short (insufficient) to fully consume the adhesion promoter 84. That is, the material 90 (the matrix material 82) is cured (crosslinking process occurs) while ensuring that a sufficient amount of adhesion promoter 84 remains in the pre-seal 92 after curing. The resulting intermediate product (pre-seal 92) is solid (cured/hardened) but has limited adhesive properties, which is to say that while it might be slightly sticky, it cannot be durably attached to a surface. This makes the pre-seal 92 easy to handle. The step 301B which is illustrated above the dashed line in Figure 3B may be performed at a supplier of the pre-seal 92, for example. The pre-seal 92 may then be shipped to a manufacturer of the power semiconductor module arrangement 100. A surface on which the pre-seal 92 is formed, therefore, may be a suitable working surface and the resulting pre-seal 92 may be removed from the working surface for further handling.

Different adhesion promoters 84 may usually be suitable to be used in a seal 8. Each adhesion promoter 84 may have a different specific activation time-temperature budget. In other words, heating a given adhesion promoter 84 at a given temperature for a given period of time will lead to activation and consumption of that adhesion promoter 84. On the other hand, heating that same adhesion promoter 84 at a higher temperature for a shorter time, or at a lower temperature for a longer time, can also lead to activation and consumption of that adhesion promoter 84. Many adhesion promoters 84 have an activation temperature of between 130°C and 150°C, and activation times of between 20 minutes and 120 minutes. That is, the temperature and time during which the first step 301B is performed depends on the specific activation time-temperature budget of the adhesion promoter 84 present in the material 90. In any case, however, the first step 301B is performed for a duration and at a temperature that is lower than the activation time-temperature budget of the adhesion promoter 84 that is used for the seal 8. The matrix material 82 that is used for a silicon based seal 8, for example, generally cures at temperatures that are significantly lower than the activation temperature of the adhesion promoter 84. The curing may even occur at relatively low temperatures such as, e.g., between 50°C and 100°C. According to one example, a curing step (step 301B) may be performed at 50°C for 2 hours, at 60°C for 1 hour, or at 80°C for 30 minutes. As noted, however, the specific temperatures and durations generally depend on the specific materials and may vary.

The resulting pre-seal 92 may be shipped and may then be arranged on a surface of a substrate 10, base plate or housing 7, and the housing 7 may be arranged on the substrate 10 or base plate with the pre-seal 92 arranged therebetween (step 302B). A second heating step may follow during which the arrangement, and in particular the pre-seal 92, is heated to temperatures which correspond to or are even higher than the activation temperature of the adhesion promoter 84 (step 303B). For example, heat may be applied to the side of the substrate 10 or base plate opposite the side to which the pre-seal 92 is mounted, effecting activation of the adhesion promoter 84, and causing the resulting seal 8 to securely attach to both the housing 7 and the substrate 10 or base plate. That is, the resulting seal 8 securely attaches the housing 7 to the substrate 10 or base plate and, in addition, seals the inside of the housing 7.

Conventional non-adhesive seals such as gaskets and o-rings can also be used to seal power modules. However, such gaskets and o-rings require use of external fasteners to provide a compressive force to maintain a seal between the housing 7 and substrate 10 or base plate at all times, both before and after curing of the casting compound 5. Again, the adhesive properties of the adhesive seal 8 according to embodiments of the disclosure mean that no additional fasteners are required after the adhesion promoter is activated so as to secure the housing 7 to the substrate 10 or base plate.

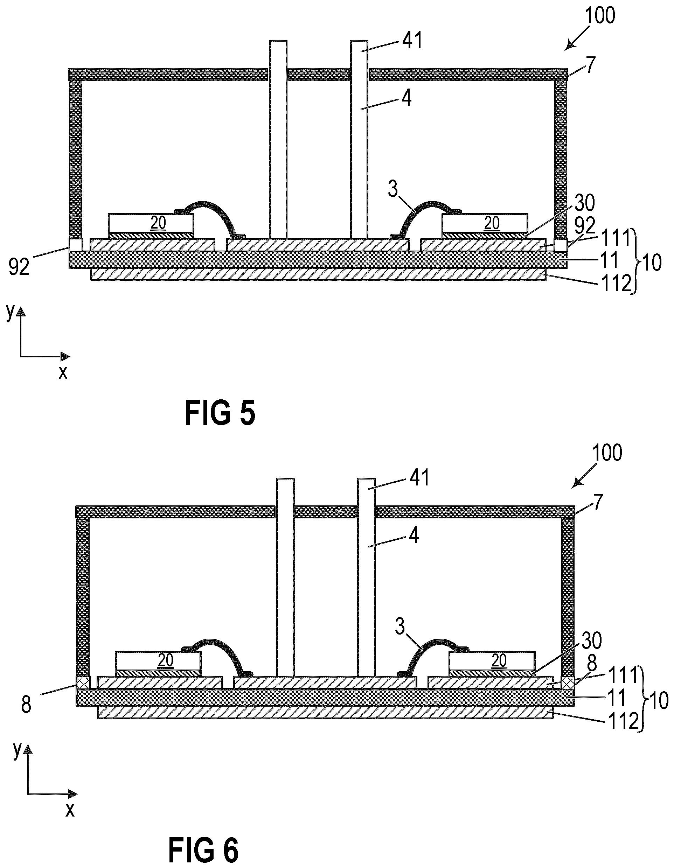

The steps 302B and 303B, as described with respect to Figure 3B above, are again illustrated by means of Figures 4, 5 and 6. As is schematically illustrated in Figure 4, a pre-produced pre-seal 92 may be arranged on a substrate 10. A housing 7 may be arranged on the substrate 10, with the pre-seal 92 arranged between the substrate 10 and the housing 7, as is illustrated in Figure 5. A heating step follows during which the adhesion promoter that is present in the pre-seal 92 (but which has not yet been activated) is activated, resulting in a seal 8 which has sealing properties as well as adhesion properties. That is, the resulting seal 8 has strong adhesion forces and securely attaches the housing 7 to the substrate 10.

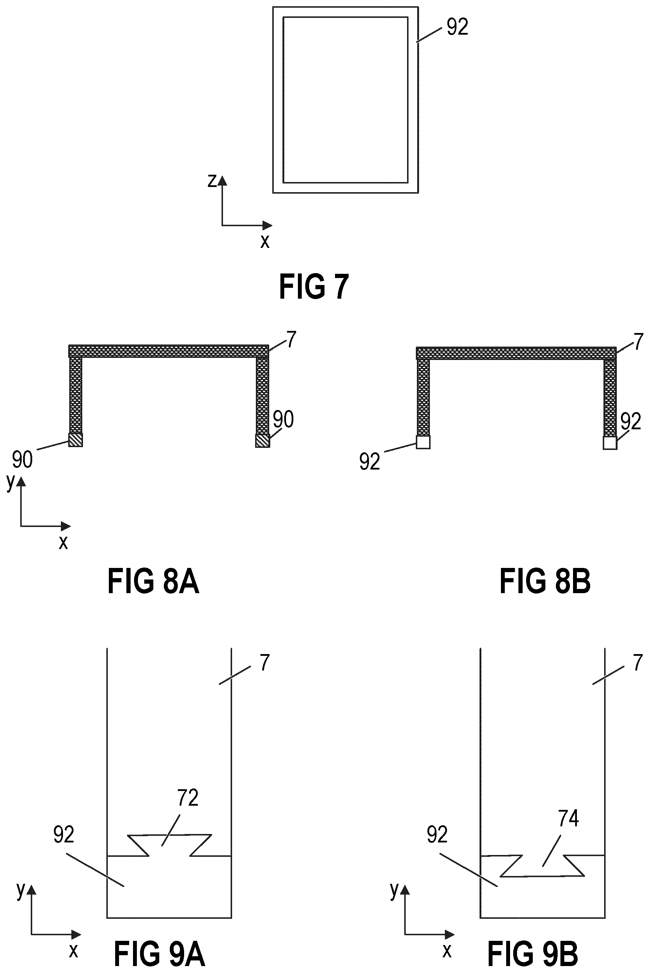

The pre-seal 92 may have any suitable form. According to one example, the pre-seal 92 forms a closed loop, as is schematically illustrated in Figure 7, for example. The shape and size of the pre-seal 92 may depend on the shape and size of the housing 7, for example. The pre-seal 92 may have the exact same shape and dimensions as the housing 7 such that it may be arranged between the housing 7 and the substrate 10 or base plate to attach the housing 7 to the substrate 10 or base plate and seal the inside of the housing 7. Many substrates 10, base plates and housings 7 have a rectangular or square shape. Other shapes, however, are generally possible. The size of the pre-seal 92 may be slightly smaller than the size of the respective substrate 10 or base plate such that, when it is arranged on the substrate 10 or base plate, it extends along its edge. When the housing 7 is arranged on the pre-seal 92, the pre-seal 92 extends along the entire circumference of the housing 7 (i.e., along the lower surface of the sidewalls of the housing 7 that face towards the substrate 10 or base plate).

Alternatively, the pre-seal 92 may be arranged on a surface of the housing 7 first. The housing 7 with the pre-seal 92 arranged thereon may then be arranged on a substrate 10. The heating step may follow as has been described above with respect to Figure 6 to form the final seal 8. If the substrate 10 is arranged on a base plate, the housing 7 may be arranged on the base plate, with the pre-seal 92 arranged between the base plate and the housing 7.

It is possible to manufacture and ship the pre-seal 92 independently. According to another embodiment falling within the scope of the present invention, however, it is also possible to form the pre-seal 92 on the housing 7 and ship the housing 7 together with the pre-seal 92 formed thereon. This is schematically illustrated in Figure 8. In a first step, the material 90 including the (silicone based) matrix material and the adhesion promoter is applied to the housing 7 (e.g., on a lower surface of the sidewalls of the housing 7 that face towards the substrate 10 or base plate when the housing 7 is arranged on the substrate 10 or base plate). This is schematically illustrated in Figure 8A. A heating step is performed to cure the matrix material without activating or without fully consuming the adhesion promoter, thereby forming the pre-seal 92 (Figure 8B). The housing 7 with the pre-seal 92 formed thereon may then be arranged on a substrate 10 or base plate and the final seal 8 may be formed by performing the second heating step as has been described above.

The lower surface of the sidewalls of the housing 7 may be a flat or essentially flat surface, as is schematically illustrated in Figure 8, for example. In this case, the pre-seal 92 is required to have certain adhesive properties in order to remain attached to the flat lower surface. It is, however, also possible that the lower surface of the sidewalls is formed to have at least one recess or undercut 72, for example. This is schematically illustrated in Figure 9A. When the material 90 is applied to the lower surface of the housing 7, the material 90 fills the recess 72 formed in the sidewall of the housing 7, and further forms a layer of material 90 that extends from the lower surface in a vertical direction y. Once the material 90 has been cured and the pre-seal 92 is solid, it is securely attached to the lower surface of the housing 7 without having any adhesive properties yet, or having only limited adhesive properties. The specific form of the recess 72 illustrated in Figure 9A is merely an example. A recess or undercut 72 may generally have any suitable form. In this case, the pre-seal 92 remains attached to the sidewall of the housing without having any adhesive properties.

A similar effect may be achieved if the lower surface of the housing 7 comprises a protrusion 74, and the material 90 is applied to the lower surface of the housing 7 such that it forms a layer of material 90 that extends from the lower surface in a vertical direction y and entirely encloses the protrusion 74, as is exemplarily illustrated in Figure 9B. The recess 72 or protrusion 74 may be a continuous recess 72 or protrusion 74 along the entire circumference of the housing 7. It is, however, also possible, that a plurality of recesses 72 and/or protrusions 74 is arranged along the circumference of the housing 7.

When forming a pre-seal 92 (either independently or on a lower surface of the housing, for example), the curing step at a temperature below the activation temperature of the adhesion promoter 84 may be carried out in a vacuum chamber, for example. This prevents air from penetrating into the material 90. The resulting pre-seal 92 as well as the final seal 8, therefore, are free of any unwanted air bubbles or cavities. Even further, any fluids or moisture that may be present in the housing 7 may be prevented from penetrating into the material 90. The resulting pre-seal 92 as well as the final seal 8, therefore, are also free of any unwanted fluids.

According to another example, a housing 7 with a pre-attached pre-seal 92 may be formed in a two-shot (2K) injection molding process, for example. Techniques that are known as 2K injection molding allow to form injection-molded parts comprising two different materials in the same mold. A first material (e.g., the material forming the housing 7) may be filled into a mold by means of at least one injection. At least one second injection is used to fill a second material (e.g., the material 90 forming the pre-seal 92) into a mold containing the housing 7, where the mold has defined locations adjacent the housing 7. The two materials, in this way, may be connected to each other. It is important that during the second step of the 2K processes, e.g., during formation of the pre-seal 92, that the temperature be held sufficiently high and for a sufficient time to allow curing of the second material 90 but at a low enough temperature and/or for a time that is short enough to prevent the adhesion promoter from being fully consumed during the curing process. The 2K injection molding process can be a manual two-step process, or a fully automated process using a rotary injection molding form, for example. The two materials may be filled into the mold in any suitable order, as long as the temperature can be held low enough or for an amount of time insufficient to allow full consumption of the adhesion promoter in the pre-seal material 90.

According to this example, the housing/pre-seal assembly 7, 92 may be mounted to a substrate 10 by placing it on the substrate 10 with the pre-seal 92 arranged between the housing 7 and the substrate 10 and by pressing the housing 7 toward the substrate. The pre-seal 92 is then heated in order to activate the adhesion promoter remaining in the pre-seal material 90, for example, by heating the other side of the substrate 10. Pressure may be removed from the housing 7 and the heat may be removed once the adhesion promoter is fully activated and the pre-seal 92 seal is fully adhered to the substrate 10

It is generally also possible to form a pre-seal 92 on a substrate 10 or base plate, similar to what has been described with respect to the housing 7 above. A housing 7 may then be arranged on the substrate 10 or base plate with the pre-seal 92 arranged between the housing 7 and the substrate 10 or base plate. The final seal 8 may be formed by performing the second heating step as has been described above.

## Claims

1. A method for forming a pre-seal (92) for a power semiconductor module arrangement (100), the method comprising:
applying a first material (90) to a first surface, the first material (90) comprising a matrix material (82) and an inactive adhesion promoter (84) wherein the matrix material (82) is configured to cure when heated to a defined temperature for a defined period of time, and wherein the adhesion promoter (84) is configured to be activated when heated to a temperature that is higher than the defined temperature and/or for a period of time that is longer than the defined period of time; and
heating the first material (90) to the defined temperature for the defined period of time such that the matrix material (82) cures and the adhesion promoter (84) remains inactive, thereby forming a pre-seal (92), wherein the pre-seal (92), when the adhesion promoter (84) is inactive, comprises no or only limited adhesive properties such that it cannot be durably attached to the surface, and wherein the pre-seal (92), when the adhesion promoter (84) is activated, comprises adhesive properties such that it can be durably attached to the surface.

2. The method of claim 1, further comprising
removing the pre-seal (92) from the first surface;
arranging the pre-seal (92) between a housing (7) and a substrate (10) or a base plate of a power semiconductor module arrangement (100); and
heating the pre-seal (92) to a temperature that is equal to the defined temperature for a period of time that is longer than the defined period of time, or to a temperature that is greater than the defined temperature for a period of time that equals or is longer than the defined period of time, thereby activating the adhesion promoter (84) and forming a seal (8) between the housing (7) and the substrate (10) or base plate, the seal (8) forming an adhesive bond with the housing (7) and with the substrate (10) or base plate.

3. The method of claim 1, wherein the first surface is a surface of a housing (7) of a semiconductor module arrangement (100), and the method further comprises
arranging the housing (7) with the pre-seal (92) arranged thereon on a substrate (10) or base plate of the semiconductor module arrangement (100); and
heating the pre-seal (92) to a temperature that is equal to the defined temperature for a period of time that is longer than the defined period of time, or to a temperature that is greater than the defined temperature for a period of time that equals or is longer than the defined period of time, thereby activating the adhesion promoter (84) and forming a seal (8) between the housing (7) and the substrate (10) or base plate, the seal (8) forming an adhesive bond with the housing (7) and with the substrate (10) or base plate.

4. The method of claim 3, further comprising
filling a material different from the first material (90) into a mold to form the housing (7), wherein
applying the first material (90) to the first surface comprises subsequently filling the first material (90) into the mold.

5. The method of claim 3 or 4, wherein
the surface of the housing (7) comprises at least one recess (72), and the first material (90) is applied to the surface such that it fills the at least one recess (72) and forms a layer of material (90) that extends from the surface in a vertical direction (y); and/or
the surface of the housing (7) comprises at least one protrusion (74), and the first material (90) is applied to the surface such that it forms a layer of material (90) that extends from the surface in a vertical direction (y) and entirely encloses the at least one protrusion (74).

6. The method of claim 1, wherein the first surface is a surface of a substrate (10) or base plate of a power semiconductor module arrangement (100), and the method further comprises
arranging a housing (7) of the power semiconductor module arrangement (100) on the substrate (10) or base plate such that the pre-seal (92) is arranged between the housing (7) and the substrate (10) or base plate; and
heating the pre-seal (92) to a temperature that is equal to the defined temperature for a period of time that is longer than the defined period of time, or to a temperature that is greater than the defined temperature for a period of time that equals or is longer than the defined period of time, thereby activating the adhesion promoter (84) and forming a seal (8) between the housing (7) and the substrate (10) or base plate, the seal (8) forming an adhesive bond with the housing (7) and with the substrate (10) or base plate.

7. The method of any of claims 1 to 6, wherein the matrix material (82) is a silicone based matrix material.

8. The method of any of the preceding claims, wherein
the defined temperature is between 50°C and 100°C; and
heating the pre-seal (92) to a temperature that is greater than the defined temperature comprises heating the pre-seal (92) to a temperature of between 130°C and 150°C.

9. The method of any of claims 2 to 8, wherein the pre-seal (92) is arranged between the housing (7) and the substrate (10) or base plate such that it extends along the entire circumference of the housing (7) along a lower surface of the sidewalls of the housing 7 that face towards the substrate (10) or base plate.

10. The method of any of the preceding claims, wherein the pre-seal (92) forms a closed loop.

11. A housing (7) for a power semiconductor module arrangement (100), the housing comprising:
sidewalls and a cover; and
a pre-seal (92) arranged on a lower surface of the sidewalls, wherein the pre-seal (92) comprises a cured matrix material (82) and an inactive adhesion promoter (84), wherein the matrix material (82) is configured to cure when heated to a defined temperature for a defined period of time, and wherein
the inactive adhesion promoter (84) is configured to be activated at or above the defined temperature and/or for a period of time that is longer than the defined period of time, wherein the pre-seal (92), when
the adhesion promoter (84) is inactive, comprises no or only limited adhesive properties such that it cannot be durably attached to the surface, and wherein the pre-seal (92), when
the adhesion promoter (84) is activated, comprises adhesive properties such that it can be durably attached to the surface.

12. The housing (7) of claim 11, wherein
the lower surface of the housing (7) comprises at least one recess (72), and the pre-seal (92) fills the at least one recess (72) and forms a layer that extends from the lower surface in a vertical direction (y); and/or
the surface of the housing (7) comprises at least one protrusion (74), and pre-seal (92) forms a layer that extends from the lower surface in a vertical direction (y) and entirely encloses the at least one protrusion (74).

## Patentansprüche

1. Verfahren zur Herstellung einer Vordichtung (92) für eine Leistungshalbleitermodulanordnung (100), wobei das Verfahren umfasst:
Aufbringen eines ersten Materials (90) auf eine erste Oberfläche, wobei das erste Material (90) ein Matrixmaterial (82) und einen inaktiven Haftvermittler (84) umfasst, wobei das Matrixmaterial (82) dafür gestaltet ist, zu härten, wenn es für einen definierten Zeitraum auf eine definierte Temperatur erhitzt wird, und wobei der Haftvermittler (84) dafür gestaltet ist, aktiviert zu werden, wenn er auf eine Temperatur erhitzt wird, die höher als die definierte Temperatur ist, und/oder für einen Zeitraum, der länger als der definierte Zeitraum ist; und
Erhitzen des ersten Materials (90) auf die definierte Temperatur für den definierten Zeitraum, so dass das Matrixmaterial (82) aushärtet und der Haftvermittler (84) inaktiv bleibt, um eine Vordichtung (92) zu bilden, wobei die Vordichtung (92), wenn der Haftvermittler (84) inaktiv ist, keine oder nur begrenzte Hafteigenschaften aufweist, so dass sie nicht dauerhaft an der Oberfläche befestigt werden kann, und wobei die Vordichtung (92), wenn der Haftvermittler (84) aktiviert ist, Hafteigenschaften aufweist, so dass sie dauerhaft an der Oberfläche befestigt werden kann.

2. Verfahren nach Anspruch 1, ferner umfassend
Entfernen der Vordichtung (92) von der ersten Oberfläche; Anordnen der Vordichtung (92) zwischen einem Gehäuse (7) und einem Substrat (10) oder einer Grundplatte einer Leistungshalbleitermodulanordnung (100); und
Erhitzen der Vordichtung (92) auf eine Temperatur, die gleich der definierten Temperatur ist, für einen Zeitraum, der länger als der definierte Zeitraum ist, oder auf eine Temperatur, die höher als die definierte Temperatur ist, für einen Zeitraum, der gleich oder länger als der definierte Zeitraum ist, um den Haftvermittler (84) zu aktivieren und eine Dichtung (8) zwischen dem Gehäuse (7) und dem Substrat (10) oder der Grundplatte zu bilden, wobei die Dichtung (8) eine Klebeverbindung mit dem Gehäuse (7) und mit dem Substrat (10) oder der Grundplatte bildet.

3. Verfahren nach Anspruch 1, wobei die erste Oberfläche eine Oberfläche eines Gehäuses (7) einer Halbleitermodulanordnung (100) ist und das Verfahren ferner umfasst
Anordnen des Gehäuses (7) mit der darauf angeordneten Vordichtung (92) auf einem Substrat (10) oder einer Grundplatte der Halbleitermodulanordnung (100); und
Erhitzen der Vordichtung (92) auf eine Temperatur, die gleich der definierten Temperatur ist, für einen Zeitraum, der länger als der definierte Zeitraum ist, oder auf eine Temperatur, die höher als die definierte Temperatur ist, für einen Zeitraum, der gleich oder länger als der definierte Zeitraum ist, um den Haftvermittler (84) zu aktivieren und eine Dichtung (8) zwischen dem Gehäuse (7) und dem Substrat (10) oder der Grundplatte zu bilden, wobei die Dichtung (8) eine Klebeverbindung mit dem Gehäuse (7) und mit dem Substrat (10) oder der Grundplatte bildet.

4. Verfahren nach Anspruch 3, ferner umfassend
Füllen eines von dem ersten Material (90) verschiedenen Materials in ein Formwerkzeug, um das Gehäuse (7) zu bilden, wobei
Aufbringen des ersten Materials (90) auf die erste Oberfläche anschließendes Füllen des ersten Materials (90) in das Formwerkzeug umfasst.

5. Verfahren nach Anspruch 3 oder 4, wobei
die Oberfläche des Gehäuses (7) wenigstens eine Aussparung (72) umfasst und das erste Material (90) so auf die Oberfläche aufgebracht wird, dass es die wenigstens eine Aussparung (72) füllt und eine Materialschicht (90) bildet, die sich von der Oberfläche in einer vertikalen Richtung (y) erstreckt; und/oder
die Oberfläche des Gehäuses (7) wenigstens einen Vorsprung (74) umfasst und das erste Material (90) so auf die Oberfläche aufgebracht wird, dass es eine Materialschicht (90) bildet, die sich von der Oberfläche in einer vertikalen Richtung (y) erstreckt und den wenigstens einen Vorsprung (74) vollständig umschließt.

6. Verfahren nach Anspruch 1, wobei die erste Oberfläche eine Oberfläche eines Substrats (10) oder einer Grundplatte einer Leistungshalbleitermodulanordnung (100) ist und das Verfahren ferner umfasst
Anordnen eines Gehäuses (7) der Leistungshalbleitermodulanordnung (100) auf dem Substrat (10) oder der Grundplatte, so dass die Vordichtung (92) zwischen dem Gehäuse (7) und dem Substrat (10) oder der Grundplatte angeordnet ist; und
Erhitzen der Vordichtung (92) auf eine Temperatur, die gleich der definierten Temperatur ist, für einen Zeitraum, der länger als der definierte Zeitraum ist, oder auf eine Temperatur, die höher als die definierte Temperatur ist, für einen Zeitraum, der gleich oder länger als der definierte Zeitraum ist, um den Haftvermittler (84) zu aktivieren und eine Dichtung (8) zwischen dem Gehäuse (7) und dem Substrat (10) oder der Grundplatte zu bilden, wobei die Dichtung (8) eine Klebeverbindung mit dem Gehäuse (7) und mit dem Substrat (10) oder der Grundplatte bildet.

7. Verfahren nach einem der Ansprüche 1 bis 6, wobei das Matrixmaterial (82) ein Matrixmaterial auf Siliconbasis ist.

8. Verfahren nach einem der vorstehenden Ansprüche, wobei
die definierte Temperatur zwischen 50 °C und 100 °C beträgt; und
Erhitzen der Vordichtung (92) auf eine Temperatur, die höher als die definierte Temperatur ist, Erhitzen der Vordichtung (92) auf eine Temperatur zwischen 130 °C und 150 °C umfasst.

9. Verfahren nach einem der Ansprüche 2 bis 8, wobei die Vordichtung (92) so zwischen dem Gehäuse (7) und dem Substrat (10) oder der Grundplatte angeordnet ist, dass sie sich entlang des gesamten Umfangs des Gehäuses (7) entlang einer unteren Oberfläche der Seitenwände des Gehäuses 7, die zu dem Substrat (10) oder der Grundplatte zeigt, erstreckt.

10. Verfahren nach einem der vorstehenden Ansprüche, wobei die Vordichtung (92) eine geschlossene Schleife bildet.

11. Gehäuse (7) für eine Leistungshalbeitermodulanordnung (100), wobei das Gehäuse umfasst:
Seitenwände und einen Deckel; und
eine Vordichtung (92), die auf einer unteren Oberfläche der Seitenwände angeordnet ist, wobei die Vordichtung (92) ein gehärtetes Matrixmaterial (82) und einen inaktiven Haftvermittler (84) umfasst, wobei das Matrixmaterial (82) dafür gestaltet ist, zu härten, wenn es für einen definierten Zeitraum auf eine definierte Temperatur erhitzt wird, und wobei
der inaktive Haftvermittler (84) dafür gestaltet ist, bei oder über der definierten Temperatur und/oder für einen Zeitraum, der länger als der definierte Zeitraum ist, aktiviert zu werden, wobei die Vordichtung (92), wenn der Haftvermittler (84) inaktiv ist, keine oder nur begrenzte Hafteigenschaften aufweist, so dass sie nicht dauerhaft an der Oberfläche befestigt werden kann, und wobei die Vordichtung (92), wenn der Haftvermittler (84) aktiviert ist, Hafteigenschaften aufweist, so dass sie dauerhaft an der Oberfläche befestigt werden kann.

12. Gehäuse (7) nach Anspruch 11, wobei
die untere Oberfläche des Gehäuses (7) wenigstens eine Aussparung (72) umfasst und die Vordichtung (92) die wenigstens eine Aussparung (72) füllt und eine Schicht bildet, die sich von der unteren Oberfläche in einer vertikalen Richtung (y) erstreckt; und/oder
die Oberfläche des Gehäuses (7) wenigstens einen Vorsprung (74) umfasst und die Vordichtung (92) eine Schicht bildet, die sich von der unteren Oberfläche in einer vertikalen Richtung (y) erstreckt und den wenigstens einen Vorsprung (74) vollständig umschließt.

## Revendications

1. Un procédé de formation d'un joint (92) préalable pour un agencement (100) de module à semiconducteur de puissance, le procédé comprenant :
appliquer une première matière (90) à une première surface, la première matière (90) comprenant une matière (82) formant matrice et un promoteur (84) d'adhérence inactif, dans lequel la matière (82) formant matrice est configurée pour durcir, lorsqu'elle est portée à une température définie pendant un laps de temps défini, et dans lequel le promoteur (84) d'adhérence est configuré pour être activé, lorsqu'il est porté à une température qui est plus haute que la température définie et/ou pendant un laps de temps plus grand que le laps de temps défini ; et
porter la première matière (90) à la température définie pendant le laps de temps défini, de manière à ce que la matière (82) formant matrice durcisse et de manière à ce que le promoteur (84) d'adhérence reste inactif en formant ainsi un joint (92) préalable, dans lequel le joint (92) préalable, lorsque le promoteur (84) d'adhérence est inactif, n'a pas de propriété adhésive ou n'a que des propriétés adhésives limitées, de sorte qu'il ne peut pas être fixé durablement à la surface, et dans lequel le joint (92) préalable, lorsque le promoteur (84) d'adhérence est activé, a des propriétés adhésives, de sorte qu'il peut être fixé durablement à la surface.

2. Le procédé de la revendication 1, comprenant en outre
retirer le joint (92) préalable de la première surface ;
mettre le joint (92) préalable entre un boîtier (7) et un substrat (10) ou une plaque de base d'un agencement (100) de module à semiconducteur de puissance ; et
porter le joint (92) préalable à une température qui est égale à la température définie pendant un laps de temps qui est plus long que le laps de temps défini ou à une température, qui est plus haute que la température définie, pendant un laps de temps qui est égal au laps de temps défini ou plus long que le laps de temps défini en activant ainsi le promoteur (84) d'adhérence et
former un joint (8) entre le boîtier (7) et le substrat (10) ou la plaque de base, le joint (8) formant une liaison adhésive avec le boîtier (7) et avec le substrat (10) ou la plaque de base.

3. Le procédé de la revendication 1, dans lequel la première surface est une surface d'un boîtier (7) d'un agencement (100) de module à semiconducteur, et le procédé comprend en outre
mettre le boîtier (7), alors que le joint (92) préalable y est mis, sur un substrat (10) ou sur une plaque de base de l'agencement (100) de module à semiconducteur ; et
porter le joint (92) préalable à une température, qui est égale à la température définie pendant un laps de temps, qui est plus long que le laps de temps défini, ou à une température, qui est plus haute que la température définie pendant le laps de temps, qui est égal au laps de temps défini ou qui est plus long que le laps de temps défini, en activant ainsi le promoteur (84) d'adhérence et en formant un joint (8) entre le boîtier (7) et le substrat (10) ou la plaque de base, le joint (8) formant une liaison adhésive avec le boîtier (7) et avec le substrat (10) ou la plaque de base.

4. Le procédé de la revendication 3, comprenant en outre
remplir un moule d'une matière différente de la première matière (90) pour former le boîtier (7), dans lequel
appliquer la première matière (90) à la première surface comprend remplir ensuite le moule de la première matière (90).

5. Le procédé de la revendication 3 ou 4, dans lequel
la surface du boîtier (7) comprend au moins un creux (72), et la première matière (90) est appliquée à la surface, de manière à ce qu'elle remplisse le au moins un creux (72) et forme une couche de matière (90), qui s'étend à partir de la surface dans une direction (y) verticale ;
et/ou
la surface du boîtier (7) comprend au moins une saillie (74), et la première matière (90) est appliquée à la surface, de manière à ce qu'elle forme une couche de matière (90), qui s'étend à partir de la surface dans une direction (y) verticale et enferme entièrement la au moins une saillie (74).

6. Le procédé de la revendication 1, dans lequel la première surface est une surface d'un substrat (10) ou d'une plaque de base d'un agencement (100) de module à semiconducteur de puissance et le procédé comprend en outre
mettre un boîtier (7) de l'agencement (100) de module à semiconducteur de puissance sur le substrat (10) ou la plaque de base, de manière à ce que le joint (92) préalable soit mis entre le boîtier (7) et le substrat (10) ou la plaque de base ; et
porter le joint (92) préalable à une température, qui est égale à la température définie pendant un laps de temps, qui est plus long que le laps de temps défini, ou à une température, qui est plus haute que la température définie pendant un laps de temps, qui est égal au laps de temps défini ou qui est plus long que le laps de temps défini, en activant ainsi le promoteur (84) d'adhérence et en formant un joint (8) entre le boîtier (7) et le substrat (10) ou la plaque de base, le joint (8) formant une liaison adhésive avec le boîtier (7) et avec le substrat (10) ou la plaque de base.

7. Le procédé de l'une quelconque des revendications 1 à 6, dans lequel la matière (82) formant matrice est une matière formant matrice à base de silicone.

8. Le procédé de l'une quelconque des revendications précédentes, dans lequel
la température définie est comprise entre 50°C et 100°C ; et
porter le joint (92) préalable à une température qui est plus haute que la température définie comprend porter le joint (92) préalable à une température comprise entre 130°C et 150°C.

9. Le procédé de l'une quelconque des revendications 2 à 8, dans lequel le joint (92) préalable est mis entre le boîtier (7) et le substrat (10) ou la plaque de base, de manière à ce qu'il s'étend le long de toute la circonférence du boîtier (7) le long d'une surface inférieure des parois latérales du boîtier (7), qui sont en face du substrat (10) ou de la plaque de base.

10. Le procédé de l'une quelconque des revendications précédentes, dans lequel le joint (92) préalable forme une boucle fermée.

11. Un boîtier (7) d'un agencement (100) de module à semiconducteur de puissance, le boîtier comprenant :
des parois latérales et un couvercle ; et
un joint (92) préalable mis sur une surface inférieure des parois latérales, dans lequel le joint (92) préalable comprend une matière (82) formant matrice durcie et un promoteur (84) d'adhérence inactif,
dans lequel la matière (82) formant matrice est configurée pour durcir, lorsqu'elle est portée à une température définie pendant un laps de temps défini, et dans lequel
le promoteur (84) d'adhérence inactif est configuré pour être activé à ou au-dessus de la température définie et/ou pendant un laps de temps, qui est plus long que le laps de temps défini, dans lequel le joint (92) préalable, lorsque le promoteur (84) d'adhérence est inactif, n'a pas de propriété adhésive ou n'a que des propriétés adhésives limitées, de sorte qu'il ne peut pas être fixé durablement à la surface, et dans lequel le joint (92) préalable, lorsque le promoteur (84) d'adhérence est activé, a des propriétés adhésives, de sorte qu'il peut être fixé durablement à la surface.

12. Le boîtier (7) de la revendication 11, dans lequel
la surface inférieure du boîtier (7) comprend au moins un creux (72) et le joint (92) préalable remplit le au moins un creux (72) et forme une couche, qui s'étend à partir de la surface inférieure dans une direction (y) verticale ; et/ou
la surface du boîtier (7) comprend au moins une saillie (74) et le joint (92) préalable forme une couche, qui s'étend à partir de la surface inférieure dans une direction (y) verticale et qui enferme entièrement la au moins une saillie (74).
